# FASCICULE DE BREVET EUROPEEN

(11) **EP 1 267 358 B1**
(45) Date de publication et mention de la délivrance du brevet: **21.11.2007**
(21) Numéro de dépôt: 02354097.4
(22) Date de dépôt: 14.06.2002
(51) Int. Cl.: G11C 17/12, H01L 21/8246, H01L 27/112

(54) **Mémoire MOS à lecture seulement**
MOS-Festwertspeicher
MOS read only memory

(30) Priorité: 15.06.2001 FR 0107872
(43) Date de publication de la demande: 18.12.2002
(73) Titulaire: STMicroelectronics S.A., 92120 Montrouge (FR)
(72) Inventeur: Thomas, Sigrid, 38100 Grenoble (FR)
(74) Mandataire: de Beaumont, Michel

(56) Documents cités:
- EP-A- 0 890 985
- DE-A- 2 543 138
- US-A- 3 914 855

## Description

La présente invention concerne la réalisation sous forme intégrée de mémoires. Plus particulièrement, la présente invention concerne l'intégration de mémoires à lecture seulement (mémoires mortes ou ROM).

De telles mémoires sont destinées au stockage de données ou fonctions destinées à être toujours disponibles et non modifiables.

Lors de la conception d'un circuit intégré comportant une telle mémoire morte, on réalise au moins un circuit mémoire prototype destiné notamment à tester que les données que l'on prévoit de stocker dans la mémoire permettent de remplir des fonctions souhaitées.

Afin de réduire le nombre de prototypes réalisés, on a proposé de réaliser la mémoire prototype sous forme d'un réseau programmable. Il est ainsi possible de modifier le nombre et l'agencement de cellules programmées ou non du réseau mémoire lors de vérifications successives.

Pour constituer la mémoire prototype programmable, on peut utiliser des cellules programmables électriquement et effaçables par exposition à des rayons ultraviolets.

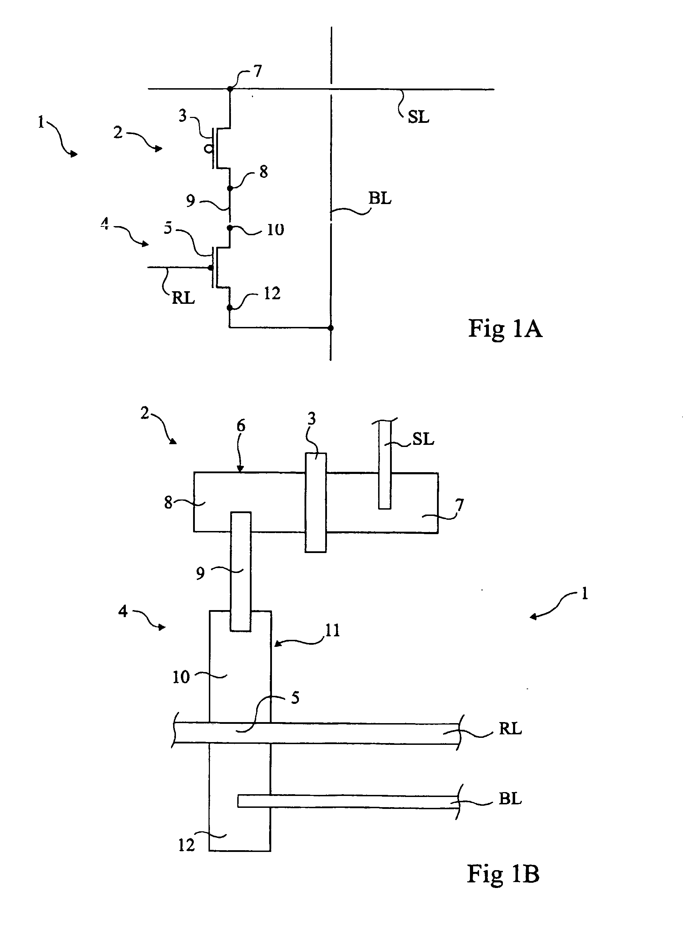

La figure 1A illustre le schéma électrique équivalent d'un mode de réalisation d'une telle cellule 1. La cellule 1 comprend, entre une ligne de sélection SL et une ligne de bits BL, la connexion série d'un élément mémoire et d'un élément de sélection. L'élément mémoire est un transistor MOS à canal P 2 dont la grille 3 est non connectée. L'élément de sélection est un transistor MOS 4. A titre d'exemple non limitatif, on considérera dans la description ci-après que le transistor de sélection 4 est à canal N. Toutefois, il pourrait également être à canal P. La grille 5 du transistor 4 est connectée à une ligne de lecture RL.

La figure 1B illustre un mode de réalisation sous forme intégrée de la cellule de la figure 1A.

Le transistor mémoire 2 est réalisé dans une première zone active 6 d'un substrat de silicium. Une zone de canal du transistor 2, définie par la grille isolée 3 non connectée, sépare, dans la zone active 6, la source 7 et le drain 8 du transistor 2. La ligne de sélection SL est en contact avec la source 7. Le drain 8 est solidaire d'une extrémité d'une liaison conductrice 9. L'autre extrémité de la liaison conductrice 9 est en contact avec la source 10 du transistor de sélection 4. Le transistor de sélection 4 est formé dans une deuxième zone active 11 du même substrat que la première zone active 6. La source 10 du transistor 4 est séparée du drain 12 par une zone de canal définie par la grille isolée 5, formée sur la zone 11. Le drain 12 du transistor de sélection 4 est en contact avec la ligne de bit BL.

Dans la réalisation d'un réseau complet, les lignes de sélection SL et de lecture RL sont communes aux cellules d'une même rangée, alors que la ligne de bit BL est commune aux cellules d'une même colonne.

Le fonctionnement d'un réseau programmable constitué de cellules identiques à la cellule- 1 de la figure 1 est le suivant. Lorsque l'on souhaite programmer une donnée dans une cellule, on sélectionne cette cellule par le biais de signaux appropriés sur la ligne de lecture RL de façon à mettre en conduction le transistor de sélection 4. Dans le cas considéré d'un transistor de sélection 4 à canal N, la ligne de lecture RL, c'est-à-dire la grille 5 du transistor 4, est amenée à un niveau de polarisation haut VDD. La ligne BL est mise à la masse. La ligne de sélection SL (source 7 du transistor 2) est amenée à un niveau de programmation VPP surélevé par rapport au niveau haut VDD. L'isolant de la grille 3 du transistor mémoire 2 est choisi de façon à permettre dans ces conditions le passage d'électrons sur la grille 3 (programmation par électrons chauds).

La lecture d'une donnée mémorisée dans une cellule programmable 1 s'effectue de la façon suivante. La ligne de sélection SL est amenée au niveau haut VDD. La grille 5 du transistor 1 est polarisée au niveau VDD de façon à mettre en conduction le transistor de sélection 4. Alors, si le transistor mémoire 2 a été préalablement programmé, celui-ci est au moins partiellement conducteur du fait des charges accumulées sur sa grille 3 non connectée. Le niveau de tension recopié par le transistor de sélection 4 sur la ligne de bit BL est alors relativement proche du niveau haut VDD. Par contre, si le transistor mémoire 2 n'a subi aucune programmation, celui-ci est totalement non-conducteur (bloqué) et la ligne BL est amenée à un niveau relativement bas par rapport au niveau haut VDD.

Pour mettre au point les données devant être contenues dans le réseau programmable, on répète la succession des étapes consistant à :
- programmer un tel réseau mémoire ;
- tester le fonctionnement du circuit ; et
- effacer par rayon ultraviolet les données du réseau.

Ces étapes sont répétées jusqu'à ce que le test fonctionnel soit satisfaisant. Une fois déterminés le nombre de cellules programmées et non programmées (vierges) et leur configuration propres au fonctionnement recherché, on fabrique un circuit intégré définitif comprenant une mémoire à lecture seulement.

Ainsi, le processus industriel classique de réalisation d'un circuit intégré contenant des données mémorisées de façon inamovible comprend les étapes de fabrication d'un circuit prototype contenant une mémoire programmable puis d'un circuit définitif contenant une mémoire morte définitive, cette mémoire morte définitive contenant par exemple un simple transistor au niveau de chaque point mémoire et étant nettement distincte de la mémoire programmable. Ceci nécessite, pour chaque circuit, la fabrication de deux jeux de masques très différents l'un de l'autre.

La présente invention vise à simplifier ce processus de fabrication.

La demanderesse a noté que le coût de fabrication globale (mémoire prototype plus mémoire définitive) peut être plus élevé que le gain résultant de l'insertion d'une mémoire morte optimisée dans le circuit définitif.

Ainsi, la présente invention vise à proposer une mémoire à lecture seulement peu différente d'une mémoire programmable.

Un autre objet de la présente invention est de proposer une telle mémoire à lecture seulement qui puisse être facilement embarquée dans un réseau mémoire comportant également un secteur programmable.

Un autre objet de la présente invention est de proposer un procédé de conversion d'une mémoire programmable en une mémoire à lecture seulement qui soit compatible avec les objectifs précédents.

Pour atteindre ces objets, la présente invention prévoit une mémoire à lecture seulement constituée de cellules dont chacune comprend, entre une ligne de sélection et une ligne de bit, la connexion en série d'un élément mémoire et d'un transistor MOS de sélection à grille connectée à une ligne de commande de lecture. Les éléments mémoire de cellules vierges sont des transistors MOS à canal P et les éléments mémoire de cellules programmées sont des régions semiconductrices uniformément dopées de type N.

Selon un mode de réalisation de la présente invention, les grilles des transistors mémoire des cellules vierges sont non connectées.

Selon un mode de réalisation de la présente invention, le transistor de sélection d'au moins une cellule vierge est à canal N et les grilles des transistors mémoire et de sélection de ladite au moins une cellule vierge sont interconnectées par une liaison conductrice.

Selon un mode de réalisation de la présente invention, la mémoire à lecture seulement est réalisée dans la même puce de circuits intégrés qu'une mémoire programmable constituée de cellules comprenant, entre une ligne de sélection et une ligne de bit, la connexion en série d'un transistor MOS à canal P dont la grille est non connectée et un transistor MOS dont la grille est connectée à une ligne de commande de lecture, les lignes de sélection des mémoires à lecture seulement et programmables étant connectables à une alimentation de sélection et les lignes de sélection de la seule mémoire programmable étant sélectivement connectables à une alimentation d'écriture distincte de ladite alimentation de sélection.

La présente invention prévoit aussi un procédé de formation, dans un substrat semiconducteur monocristallin, d'une mémoire à lecture seulement, comprenant les étapes consistant à définir des premières et deuxièmes zones actives de même dimension ; former des lignes isolées au-dessus des deuxièmes zones et de certaines des premières zones ; implanter les parties découvertes desdites premières et deuxièmes zones actives ; déposer un isolant sur l'ensemble de la structure ; ouvrir ledit isolant de façon à découvrir partiellement chacune des premières et deuxièmes zones, au voisinage de chacune de ses extrémités ; et former des lignes de sélection en contact avec les premières zones actives, des liaisons conductrices de façon à apparier chaque première zone active à une deuxième zone active et des lignes de bit en contact avec lesdites deuxièmes zones actives.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1A est un schéma électrique d'une cellule élémentaire d'un réseau programmable classique ;
la figure 1B est une vue de dessus partielle et schématique d'un exemple de réalisation sous forme intégrée de la cellule de la figure 1A ;
les figures 2A et 2B illustrent schématiquement une cellule programmée d'un réseau mémoire à lecture seulement selon un mode de réalisation de la présente invention ; et
les figures 3A et 3B illustrent schématiquement une cellule vierge (non programmée) d'un réseau mémoire à lecture seulement selon un mode de réalisation de la présente invention.

Par souci de clarté, les mêmes éléments sont désignés aux différentes figures par de mêmes références. En outre, comme cela est habituel dans la représentation de circuits intégrés, les vues de dessus des figures 1B, 2A et 3A ne sont pas représentées à l'échelle.

Une caractéristique de la présente invention consiste à utiliser comme cellules élémentaires d'une mémoire morte, en fonction de leur état programmé ou non programmé (vierge), des cellules identiques ou similaires à une cellule programmable telle que la cellule 1 de la figure 1B.

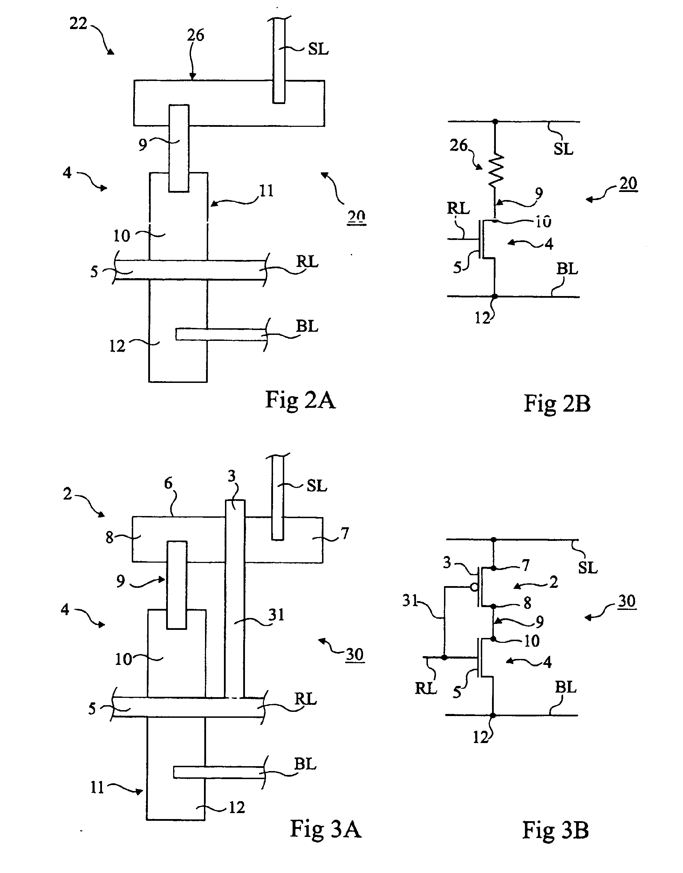

La figure 2A illustre schématiquement, en vue de dessus partielle, la réalisation sous forme monolithique d'une cellule programmée 20 selon un mode de réalisation de la présente invention. La figure 2B est un schéma électrique équivalent de la cellule 20 de la figure 2A.

Une cellule programmée 20 comprend un élément de sélection identique à celui d'une cellule programmable décrite précédemment (1, figure 1). Il s'agit, par exemple, d'un transistor MOS 4, de préférence à canal N, formé dans une zone active 11 d'un substrat semiconducteur. La cellule programmée 20 comporte également un élément mémoire 22 similaire à l'élément mémoire 2 de la cellule programmable 1 de la figure 1B. Toutefois, la grille du transistor constituant l'élément mémoire programmable 2 est supprimée. Ainsi, l'élément mémoire 22 n'est plus constitué d'un transistor MOS, mais d'une zone active 26 uniformément dopée qui se comporte comme une résistance.

Comme l'illustre la figure 2B, la cellule programmée 20 comprend, entre la ligne de sélection SL et la ligne de bit BL, la connexion série de la résistance constituée par la zone mémoire 26 et du transistor de sélection 4.

Lors d'une opération de lecture, la ligne de sélection SL est polarisée à un niveau haut VDD. La grille 5 du transistor de sélection 4 est polarisée par la ligne de lecture RL à un niveau de lecture mettant en conduction le transistor de sélection 4. Dans le cas d'un transistor de sélection 4 à canal N, le niveau de lecture est égal au niveau haut VDD. Alors, la zone mémoire 26 se comporte comme une résistance. Le transistor de sélection 4 recopie donc sur la ligne de bit BL un niveau voisin du niveau de tension haut VDD de la ligne de sélection SL.

Selon un mode de réalisation de la présente invention, une cellule vierge (non programmée) d'une mémoire morte est identique à une cellule programmable 1 de la figure 1B dans laquelle aucune donnée n'a été mémorisée. Le transistor mémoire 2 est toujours non-conducteur. Lors d'un accès de lecture, le transistor de sélection 4 recopie donc sur la ligne de bit BL un niveau relativement bas par rapport au niveau haut VDD.

Le recours selon l'invention à une mémoire à lecture seulement dont les cellules programmées et vierges sont telles que décrites précédemment est particulièrement avantageux. En particulier, son obtention à partir du réseau programmable prototype est aisée. En effet, il suffit de modifier le seul masque de définition des grilles de transistors de façon à éliminer celles des éléments mémoire de cellules programmées. Dans de nombreux cas, la réduction du coût de fabrication résultant de l'utilisation d'un jeu de masques similaire à celui utilisé pour la réalisation du prototype programmable compense l'augmentation de surface d'intégration par rapport à une mémoire morte optimisée.

La figure 3A illustre, en vue de dessus schématique et partielle, un autre mode de réalisation d'une cellule vierge 30 selon la présente invention. La figure 3B illustre le schéma électrique équivalent de la cellule 30 de la figure 3A.

L'élément de sélection est un transistor MOS à canal N 4 (il ne peut plus s'agir d'un transistor MOS à canal P). La grille 3 du transistor mémoire 2 est connectée, par une liaison conductrice 31, à la grille 5 du transistor de sélection 4.

La présence de la liaison 31 permet avantageusement d'éviter une auto-programmation du transistor mémoire 2. En effet, si lors d'un accès en lecture, des électrons passent sur la grille 3, en raison du niveau haut VDD de la ligne de sélection SL, ils sont dérivés par la ligne de lecture RL qui, pour mettre en conduction le transistor de sélection complémentaire 4, est également au niveau haut VDD. Le transistor mémoire 2 reste alors toujours bloqué (non-conducteur).

Comme cela a été indiqué précédemment, les cellules programmées (20, figure 2) et vierges d'une mémoire à lecture seulement selon l'invention sont formées par un procédé similaire à celui de formation d'un réseau programmable :
des zones actives sont définies dans un substrat de silicium ;
des grilles isolées sont formées au-dessus de toutes les zones actives sauf celles (26) destinées à constituer les éléments mémoire de cellules programmées 20 ;
des dopants appropriés sont implantés dans chacune des zones actives ; et
des contacts entre les régions semiconductrices appropriées et les liaisons ou lignes conductrices 9, SL, RL et BL sont formées.

Dans le cas de cellules à lecture seulement vierges du type de la cellule 30 de la figure 3, les liaisons 31 d'inter-connexion des grilles 3 et 5 de transistors mémoire 2 et de sélection 4 sont réalisées, de préférence, en même temps que les grilles 3 et 5. Ainsi, de nouveau, seul le masque de définition des grilles est modifié par rapport au jeu de masques utilisé pour la fabrication du réseau prototype programmable.

Une mémoire à lecture seulement selon la présente invention peut donc simplement être réalisée simultanément à une mémoire programmable telle que décrite en relation avec la figure 1.

De préférence, le réseau mémoire global partagera les mêmes lignes de bit. Toutefois, les lignes de sélection sont affectées par secteur en fonction de la nature programmable ou à lecture seulement du secteur considéré. Ainsi, dans un secteur de mémoire morte, les lignes de sélection sont propres à être polarisées au plus au niveau haut VDD. Par contre, dans un secteur de mémoire programmable, les lignes de sélection sont propres à être polarisées soit à un niveau haut VDD, soit à un niveau de programmation VPP surélevé par rapport au niveau haut VDD.

Les avantages de la formation d'un réseau mémoire comportant des secteurs programmables et des secteurs à lecture seulement sont nombreux.

Ainsi, lors des étapes de conception décrites précédemment, il est possible de stocker dans le secteur à lecture seulement des informations, par exemple relatives au concepteur, à la finalité du circuit, ou encore un code d'accès à la matrice afin d'en interdire le cas échéant l'accès à un utilisateur non autorisé.

Il est également possible lors des étapes de test de disposer d'un secteur à lecture seulement mémorisant les données ou les fonctions à traiter et un secteur programmable dans lequel est réalisée la fonction à mettre en oeuvre. Lors des étapes successives de test et de modification, seul le secteur programmable est effaçable et accessible au concepteur. Ceci réduit le temps de test des circuits du temps classiquement nécessaire pour reprogrammer les données ou fonctions certaines maintenant contenues dans la mémoire à lecture seulement.

La conversion d'un secteur programmable en un secteur à lecture seulement est relativement simple et peut être effectuée entre deux prototypes. Ainsi, à partir d'un réseau programmable, une première série de test peut montrer un fonctionnement correct d'une partie du réseau. Alors, cette partie est transformée en mémoire à lecture seulement interdite d'accès au testeur, d'une part, en rendant impossible la polarisation de ses lignes de sélection à un niveau de polarisation de programmation VPP et, d'autre part, en réduisant une fenêtre d'éclairement U.V. prévue en regard de la seule partie programmable.

On peut prévoir un seul circuit de lecture commun au réseau programmable et au réseau à lecture seulement, ce qui divise sensiblement par deux la surface occupée par les circuits de lecture par rapport au cas où les réseaux programmables et à lecture seulement sont des blocs mémoires de natures distinctes.

Enfin, maintenir un réseau programmable permet à un éventuel utilisateur d'introduire de nouvelles données ou de modifier une fonction.

La présente invention est susceptible de diverses variantes et modifications qui apparaîtront à l'homme de l'art. En particulier, la présente invention a été décrite précédemment à titre non-limitatif en relation avec les figures 2 et 3 dans le cas de l'association d'un élément mémoire et d'un transistor de sélection de type à canal N. Toutefois, l'invention s'appliquerait également au cas d'un transistor de sélection à canal P. Dans ce dernier cas cependant, les grilles des transistors de sélection et mémoire des cellules vierges de la mémoire à lecture seulement ne seront pas interconnectées. Les grilles des transistors mémoire des cellules vierges seront non connectées alors que les grilles des transistors de sélection associés seront reliées à une ligne de lecture respective RL.

## Revendications

1. Mémoire à lecture seulement constituée de cellules dont chacune comprend, entre une ligne de sélection (SL) et une ligne de bit (BL), la connexion en série d'un élément mémoire et d'un transistor MOS de sélection (4) à grille (5) connectée à une ligne de commande de lecture (RL), **caractérisée en ce que** les éléments mémoire de cellules vierges (30) sont des transistors MOS à canal P (2) ; et **en ce que** les éléments mémoire de cellules programmées (20) sont des régions semiconductrices uniformément dopées de type N (26).

2. Mémoire selon la revendication 1, **caractérisé en ce que** les grilles (3) des transistors mémoire (2) des cellules vierges (30) sont non connectées.

3. Mémoire selon la revendication 1, **caractérisé en ce que** le transistor de sélection (4) d'au moins une cellule vierge est à canal N et **en ce que** les grilles (3, 5) des transistors mémoire (2) et de sélection (4) de ladite au moins une cellule vierge sont interconnectées par une liaison conductrice (31).

4. Mémoire selon l'une quelconque des revendications 1 à 3, **caractérisée en ce que** la mémoire à lecture seulement est réalisée dans la même puce de circuits intégrés qu'une mémoire programmable constituée de cellules (1) comprenant, entre une ligne de sélection (SL) et une ligne de bit (BL), la connexion en série d'un transistor MOS à canal P (2) dont la grille (3) est non connectée et un transistor MOS (4) dont la grille (5) est connectée à une ligne de commande de lecture (RL), les lignes de sélection des mémoires à lecture seulement et programmable étant connectables à une alimentation de sélection (VDD) et les lignes de sélection de la seule mémoire programmable étant sélectivement connectables à une alimentation d'écriture (VPP) distincte de ladite alimentation de sélection.

5. Procédé de formation, dans un substrat semiconducteur monocristallin, d'une mémoire à lecture seulement, **caractérisée en ce qu**'il comprend les étapes suivantes :
définir des premières (6 ; 26) et deuxièmes (11) zones actives de même dimension ;
former des lignes isolées (3, 5) au-dessus des deuxièmes zones et de certaines des premières zones (6) ;
implanter les parties découvertes desdites premières et deuxièmes zones actives ;
déposer un isolant sur l'ensemble de la structure ;
ouvrir ledit isolant de façon à découvrir partiellement chacune des premières et deuxièmes zones, au voisinage de chacune de ses extrémités ; et
former des lignes de sélection (SL) en contact avec les premières zones actives, des liaisons conductrices (9) de façon à apparier chaque première zone active à une deuxième zone active et des lignes de bit (BL) en contact avec lesdites deuxièmes zones actives.

## Claims

1. A read-only memory formed of cells, each of which includes, between a selection line (SL) and a bit line (BL), the series connection of a memory element and of a selection MOS transistor (4) with a gate (5) connected to a read control line (RL), **characterized in that** the memory elements of blank cells (30) are P-channel MOS transistors (2); and the memory elements of programmed cells (20) are uniformly N-type doped semiconductor regions (26).

2. The memory of claim 1, wherein the gates (3) of the memory transistors (2) of the blank cells (30) are unconnected.

3. The memory of claim 1, wherein the selection transistor (4) of at least one blank cell is an N-channel transistor and wherein the gates (3, 5) of the memory (2) and selection (4) transistors of said at least one blank cell are interconnected by a conductive connection (31).

4. The memory of any of claims 1 to 3, wherein the read-only memory is formed in the same integrated circuit chip as a programmable memory formed of cells (1) including, between a selection line (SL) and a bit line (BL), the series connection of a P-channel MOS transistor (2), the gate (3) of which is unconnected, and of a MOS transistor (4), the gate (5) of which is connected to a read control line (RL), the lines of selection of the read-only and programmable memories being connectable to a selection power supply (VDD) and the lines of selection of the sole programmable memory being selectively connectable to a write power supply (VPP) distinct from said selection power supply.

5. A method for forming, in a single-crystal semiconductor substrate, a read-only memory, **characterized in that** it includes the steps of:
defining first (6; 26) and second (11) active areas of same dimension;
forming isolated lines (3, 5) above the second areas and some of the first areas (6);
implanting the exposed portions of said first and second active areas;
depositing an insulator over the entire structure;
opening said insulator to partially expose each of the first and second areas, in the vicinity of each of its ends; and
forming selection lines (SL) in contact with the first active areas, conductive connections (9) to match each first active area with a second active area, and bit lines (BL) in contact with said second active areas.

## Patentansprüche

1. Ein Nur-Lese-Speicher, der aus Zellen gebildet ist, von denen jede zwischen einer Auswahlleitung (selection line, SL) und einer Bit-Leitung (BL), die serielle Verbindung eines Speicherelements und eines Auswahl-MOS-Transistors (4) mit einem Gatter (5) das mit einer Lesesteuerleitung (read control line, RL) verbunden ist, beinhaltet, **dadurch gekennzeichnet, dass** die Speicherelemente von leeren Zellen (30) P-Kanal-MOS-Transistoren (2) sind; und die Speicherelemente von programmierten Zellen (20) gleichförmig N-Typ-dotierte-Halbleiterregionen (26) sind.

2. Speicher nach Anspruch 1, wobei die Gatter (3) der Speichertransistoren (2) der leeren Zellen (30) unverbunden sind.

3. Speicher nach Anspruch 1, wobei der Auswahltransistor (4) von wenigstens einer leeren Zelle ein N-Kanal-Transistor ist und wobei die Gatter (3, 5) von dem Speicher (2) und Auswahltransistoren (4) von der mindestens einen leeren Zelle mit einer leitenden Verbindung (31) verbunden sind.

4. Speicher nach irgendeinem der Ansprüche 1 bis 3, wobei der Nur-Lese-Speicher in dem gleichen integrierten Schaltungs-Chip gebildet ist, wie ein programmierbarer Speicher, der gebildet ist aus Zellen (1), die zwischen einer Auswahlleitung (SL) und einer Bit-Leitung (BL) Folgendes beinhalten: die serielle Verbindung von einem P-Kanal-MOS-Transistor (2), dessen Gatter (3) unverbunden ist und von einem MOS-Transistor (4), dessen Gatter (5) mit einer Lesesteuerleitung (RL) verbunden ist und wobei die Auswahlleitungen der Nur-Lese- und programmierbaren Speicher verbindbar sind mit einer Auswahlleistungsversorgung (VDD) und die Auswahlleitungen des alleinig programmierbaren Speichers selektiv verbindbar sind mit einer Schreibleistungsversorgung (VPP), die von der Auswahlleistungsversorgung verschieden ist.

5. Ein Verfahren zum Bilden, in einem Einkristall-Halbleiter-Substrat, eines Nur-Lese-Speichers, **dadurch gekennzeichnet, dass** es die folgenden Schritte aufweist:
Definieren erster (6; 26) und zweiter (11) aktiver Gebiete der gleichen Dimension;
Bilden isolierter Leitungen (3, 5) oberhalb der zweiten Gebiete und einiger der ersten Gebiete (6);
Implantieren der ausgesetzten bzw. exponierten Teile der ersten und zweiten aktiven Gebiete;
Abscheiden eines Isolators über der gesamten Struktur;
Öffnen des Isolators zum teilweisen Exponieren jedes der ersten und zweiten Gebiete in der Nähe von jedem seiner Enden; und
Bilden von Auswahlleitungen (SL) in Kontakt mit den ersten aktiven Gebieten, von leitenden Verbindungen (9) zum Anpassen bzw. Paaren jedes ersten aktiven Gebiets mit einem zweiten aktiven Gebiet und von Bit-Leitungen (BL) in Kontakt mit den zweiten aktiven Gebieten.
